# EUROPEAN PATENT APPLICATION

(11) **EP 4 488 880 A1**
(43) Date of publication of application: **08.01.2025**
(21) Application number: 24183403.5
(22) Date of filing: 20.06.2024
(51) Int. Cl.: G06N 3/045, G06N 5/022, G06N 20/00

(54) **GENERATING CONCEPTUAL MODELS OF PHYSICAL SYSTEMS USING SYMBIOTIC INTEGRATION OF GENERATIVE AI AND MODEL-DRIVEN ENGINEERING**

(30) Priority: 07.07.2023 IN 202321045927
(71) Applicant: Tata Consultancy Services Limited, Maharashtra (IN)
(72) Inventor: DUTTA, Jaya, 411028 Pune, Maharashtra (IN); BARAT, Souvik, 411028 Pune, Maharashtra (IN); REDDY, SREEDHAR SANNAREDDY, 411057 Pune, Maharashtra (IN); KULKARNI, VINAY, 411057 Pune, Maharashtra (IN)
(74) Representative: Goddar, Heinz J.

(57) **Abstract**

Dependency on limited availability of subject matter experts (SMEs) who are well versed in Model-Driven Engineering (MDE) technology is a significant barrier to MDE utilized for generating conceptual models. In the present disclosure, MDE and generative Artificial Intelligence (AI) operate in a symbiotic relationship complimenting respective strengths and overcoming limitations. The generative AI techniques lower the knowledge barrier and enable domain SMEs to construct purposive models by operating at natural language level instead of at MDE technology level, thereby simplifying the method of generating conceptual models that are purposive. When operating at natural language level, the method and system of the present disclosure ensures that the generative AI receives focused and well directed prompts to optimize the number of interactions and reduce computing power utilized. The method and system of the present disclosure also address limitations of generative AI platforms such as attention fading, non-deterministic behavior and hallucination.

## Description

### CROSS-REFERENCE TO RELATED APPLICATIONS AND PRIORITY

The present application claims priority to Indian application, Application No. 202321045927, filed in India on 7th July 2023.

### TECHNICAL FIELD

The disclosure herein generally relates to the field of Model-Driven Engineering (MDE), and, more particularly, to systems and methods for generating conceptual models of physical systems using symbiotic integration of generative Artificial Intelligence (AI) and MDE.

### BACKGROUND

Model-Driven Engineering (MDE) proposes models as primary artefacts for analysis, simulation, software development and the like. While MDE has delivered on the promise of enhanced productivity through automation, it continues to pose a significant entry barrier for Subject Matter Experts (SME) who are typically not well-versed with MDE technology. With modelling gaining traction for analysis-heavy use cases like decision-making and regulatory compliance where domain SMEs play a central role, this barrier is beginning to challenge even more. Industry scale models are typically large, necessitating a team of SMEs to work in a coordinated manner which requires sharing of outputs and persistence across sessions. Enterprises need to respond to change drivers addressing multiple concerns. Moreover, consequences of incorrect response are prohibitively expensive and there is seldom a room for later course correction. Relying on human experts to quickly arrive at right response is turning out to be ineffective. Therefore, there is a critical need for suitable automation support to help SMEs respond to change drivers effectively.

### SUMMARY

Embodiments of the present disclosure present technological improvements as solutions to one or more of the above-mentioned technical problems recognized by the inventors in conventional systems.

In an aspect, there is provided a processor implemented method comprising: receiving, via one or more hardware processors, a purpose and an initial context for a metamodel representative of a physical system; obtaining, via the one or more hardware processors, a description of the metamodel by performing model to text transformation; creating, via the one or more hardware processors, a plurality of objective elements of the metamodel, as a first ordered list of metamodel entities and associations thereof; generating, via the one or more hardware processors, a prompt corresponding to the metamodel representative of the physical system and the received purpose; initiating a communication, via the one or more hardware processors, with (i) one or more generative Artificial Intelligence (AI) platforms or (ii) multiple sessions of the one or more generative AI platforms, by querying the generated prompt; iteratively building the conceptual model, via the one or more hardware processors, wherein the building of the conceptual model comprises: generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt; obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms; and processing the obtained response from each of (i) the one or more generative AI platforms or (ii) the multiple sessions of the one or more generative AI platforms, to generate the conceptual model of the physical system as an instance of the metamodel representative of the physical system, using a text to model transformation; until, each of the metamodel entities and associations from the first ordered list are navigated, wherein each iteration focuses on a single entity association from the first ordered list, thereby generating a focused prompt and a focused response thereof.

In another aspect, there is provided a system comprising a memory storing instructions; one or more communication interfaces; and one or more hardware processors coupled to the memory via the one or more communication interfaces, wherein the one or more hardware processors are configured by the instructions to: receive a purpose and an initial context for a metamodel representative of a physical system; obtain a description of the metamodel by performing model to text transformation; create a plurality of objective elements of the metamodel, as a first ordered list of metamodel entities and associations thereof; generate a prompt corresponding to the metamodel representative of the physical system and the received purpose; initiate a communication, with (i) one or more generative AI platforms or (ii) multiple sessions of the one or more generative AI platforms, by querying the generated prompt; iteratively build the conceptual model, wherein the building of the conceptual model comprises: generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt; obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms; and processing the obtained response from each of (i) the one or more generative AI platforms or (ii) the multiple sessions of the one or more generative AI platforms, to generate the conceptual model of the physical system as an instance of the metamodel representative of the physical system, using a text to model transformation; until, each of the metamodel entities and associations from the first ordered list are navigated, wherein each iteration focuses on a single entity association from the first ordered list, thereby generating a focused prompt and a focused response thereof.

In yet another aspect, there are provided one or more non-transitory machine-readable information storage mediums comprising one or more instructions which when executed by one or more hardware processors cause: receiving a purpose and an initial context for a metamodel representative of a physical system; obtaining a description of the metamodel by performing model to text transformation; creating a plurality of objective elements of the metamodel, as a first ordered list of metamodel entities and associations thereof; generating a prompt corresponding to the metamodel representative of the physical system and the received purpose; initiating a communication with (i) one or more generative AI platforms or (ii) multiple sessions of the one or more generative AI platforms, by querying the generated prompt; iteratively building the conceptual model wherein the building of the conceptual model comprises: generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt; obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms; and processing the obtained response from each of (i) the one or more generative AI platforms or (ii) the multiple sessions of the one or more generative AI platforms, to generate the conceptual model of the physical system as an instance of the metamodel representative of the physical system, using a text to model transformation; until, each of the metamodel entities and associations from the first ordered list are navigated, wherein each iteration focuses on a single entity association from the first ordered list, thereby generating a focused prompt and a focused response thereof.

In accordance with an embodiment of the present disclosure, the processing of the obtained response from each of (i) the one or more generative AI platforms or (ii) the multiple sessions of the one or more generative AI platforms, to generate the conceptual model of the physical system comprises: assessing semantic validity of the obtained response from each of (i) the one or more generative AI platforms or (ii) the multiple sessions of the one or more generative AI platforms by querying an internal knowledge base; extracting a model type from each response generated from (i) the one or more generative AI platforms or (ii) the multiple sessions of the one or more generative AI platforms; creating an instance of the metamodel representative of the physical system based on the extracted model type by parsing the obtained response from each of (i) the one or more generative AI platforms or (ii) the multiple sessions of the one or more generative AI platforms, in the event that the obtained response is semantically valid; and updating a model repository of generated conceptual models in each iteration with the created instance of the metamodel representative of the physical system if the created instance of the metamodel representative of the physical system does not exist in the model repository

In accordance with an embodiment of the present disclosure, the step of assessing semantic validity of the obtained response from each of (i) the one or more generative AI platforms or (ii) the multiple sessions of the one or more generative AI platforms is repeated by querying (i) the one or more generative AI platforms or (ii) the multiple sessions of the one or more generative AI platforms, with an updated prompt having additional information from the internal knowledge base, if the obtained response is not a semantically valid response, wherein the additional information addresses hallucination associated with the one more generative AI platforms.

In accordance with an embodiment of the present disclosure, the one or more hardware processors are configured to perform the step of assessing semantic validity of the obtained response from each of (i) the one or more generative AI platforms or (ii) the multiple sessions of the one or more generative AI platforms is repeated by querying (i) the one or more generative AI platforms or (ii) the multiple sessions of the one or more generative AI platforms with a repeated prompt in the event that i) the one or more generative AI platforms or (ii) the multiple sessions of the one or more generative AI platforms return an error.

In accordance with an embodiment of the present disclosure, the step of updating a model repository of generated conceptual models in each iteration with the created instance of the metamodel representative of the physical system is followed by adding the created instance of the metamodel representative of the physical system as the current context in the second ordered list of evolving contexts

In accordance with an embodiment of the present disclosure, the updated model repository is added to the internal knowledge base for a next iteration associated with the purpose

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 illustrates an exemplary block diagram of a system for generating conceptual models of physical systems using symbiotic integration of generative Artificial Intelligence (AI) and Model-Driven Engineering (MDE), in accordance with some embodiments of the present disclosure.
FIG.2 illustrates an input/output diagram of the system of FIG. 1, in accordance with some embodiments of the present disclosure.
FIG.3 illustrates an exemplary flow diagram of a computer implemented method for generating conceptual models of physical systems using symbiotic integration of generative AI and MDE, in accordance with some embodiments of the present disclosure.
FIG.4A through FIG.4B illustrate a computer implemented method for generating conceptual models of physical systems using symbiotic integration of generative AI and MDE, in accordance with some embodiments of the present disclosure.
FIG.5 illustrates generative AI led knowledge exploration, in accordance with some embodiments of the present disclosure.
FIG.6 illustrates an extract of a use case of the computer implemented method of FIG.4A through FIG.4B, in accordance with some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

A future enterprise will be a complex ecosystem (or system of systems) of socio-cyber-physical actors that operates in a dynamic and uncertain environment. It will need to continue delivering its goals whilst dealing with unforeseen changes along multiple dimensions such as customer needs, competitor actions, regulatory regime, law of the land, and technology advance or obsolescence. Also, goals themselves may change with opening of new opportunities, constraining the existing ones, disruptions like pandemics etc.

These dynamics will play out across three planes of an enterprise including:
- Strategy: dealing with the purpose of the enterprise leading to its goals and associated strategies.
- Process: dealing with operationalization of the strategy in terms of business processes, roles, and responsibilities.
- Systems dealing with the automation of business processes involving socio-cyber-physical actors.

Enterprise needs to be responsive to a variety of change drivers at each plane, for instance, competitor actions such as introduction of new products / services, new business models, etc.; regulatory changes such as Know Your Customer (KYC), General Data Protection Regulation (GDPR), etc. that affect operational processes; events such as mergers and acquisitions that necessitate product rationalization, process re-engineering, organizational restructuring, people re-skilling, etc.; technology advance and obsolescence that necessitate modernization of IT systems; black swan events such as pandemics that affect the entire value chain and the like.

Enterprises need to respond to these change drivers addressing multiple concerns. For instance, the strategy plane needs to address concerns such as: Are the goals set at the right level? Is the current strategy optimal with respect to these goals? If not, what's the optimal strategy? Process plane needs to address concerns such as: Is the current process the right one to implement the desired strategy optimally? If not, what is the optimal process and what are the adaptive interventions necessary in the current process? Systems plane needs to address concerns such as: What are the right adaptive interventions at the software level and how can they be effectively introduced?

Given the increased rate of change, the time window available for bringing the three planes back in sync will continue to shrink. Responsive decision making in the face of uncertainty and swift adaptation so as to support continuous transformation without compromising on certainty is the need of the hour. Automation support for Subject Matter Experts (SMEs) to address these needs, is provided by Model-Driven Engineering (MDE), wherein the focus shifts to creation of problem-specific models and using these models for automated validation, simulation, analysis, synthesis, and transformation. However, modelling is a special skill requiring deep knowledge of the problem domain, the solution domain, and modelling languages. Dependency on limited availability of SMEs proves to be a significant barrier to MDE.

In accordance with the present disclosure, MDE and generative Artificial Intelligence (AI) operate in a symbiotic relationship complimenting respective strengths and overcoming limitations. The generative AI techniques are employed to significantly lower the knowledge barrier by reducing dependency on human experts or SMEs. The entry barrier to SMEs is reduced by enabling natural language interaction instead of depending on SMEs who are well versed with MDE technology level. The purposive or purpose driven conceptual models are created automatically as an output of the generative AI. When operating at natural language level, the method and system of the present disclosure ensures that the generative AI works receives focused and well directed prompts to optimize the number of interactions and reduce computing power utilized.

The responses from the Generative AI are parsed and the created conceptual models are persisted in the model repository. The created conceptual models are also stored in the context component for further prompt generation. Each prompt and thereby each semantically valid response is related to a particular association being traversed and hence the created conceptual model and the response are aligned, and persistence is attained. The persistence of the created conceptual models facilitates sharing of the conceptual models across multiple sessions. The traceability of the created conceptual models to the output of the generative AI platforms is maintained to support prompt generation.

While enabling efficient generation of conceptual models, the method and system of the present disclosure also addresses the limitations of generative AI including addressing the limited context window size problem, the fading attention problem, non-deterministic behavior, and hallucination as explained later in the description.

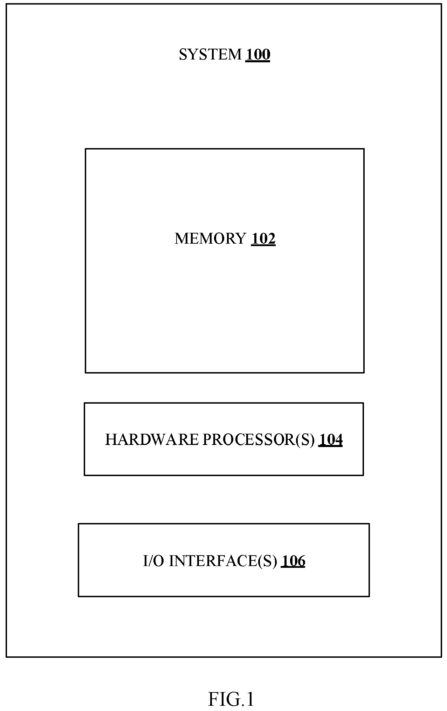

Referring now to the drawings, and more particularly to FIG. 1 through FIG.6, where similar reference characters denote corresponding features consistently throughout the figures, there are shown preferred embodiments and these embodiments are described in the context of the following exemplary system and/or method.

FIG. 1 illustrates an exemplary block diagram of a system for generating conceptual models of physical systems using symbiotic integration of generative AI and MDE, in accordance with some embodiments of the present disclosure. In the context of the present disclosure, the generated conceptual models pertain to physical systems including software systems, socio technical systems, and the like. Furthermore, in an embodiment of the present disclosure, Large Language Models (LLMs) are utilized as a platform for generative AI employed in the method and system of the present disclosure and may be interchangeably used in place of generative AI platforms.

In an embodiment, the system 100 includes one or more hardware processors 104, communication interface (s) or input/output (I/O) interface(s) 106, and one or more data storage devices or memory 102 operatively coupled to the one or more hardware processors 104. The one or more hardware processors 104 can be implemented as one or more microprocessors, microcomputers, microcontrollers, digital signal processors, central processing units, state machines, graphics controllers, logic circuitries, and/or any devices that manipulate signals based on operational instructions. Among other capabilities, the processor(s) are configured to fetch and execute computer-readable instructions stored in the memory. In the context of the present disclosure, the expressions 'processors' and 'hardware processors' may be used interchangeably. In an embodiment, the system 100 can be implemented in a variety of computing systems, such as laptop computers, notebooks, hand-held devices, workstations, mainframe computers, servers, a network cloud and the like.

The communication interface (s) 106 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. In an embodiment, the I/O interface(s) can include one or more ports for connecting a number of devices to one another or to another server.

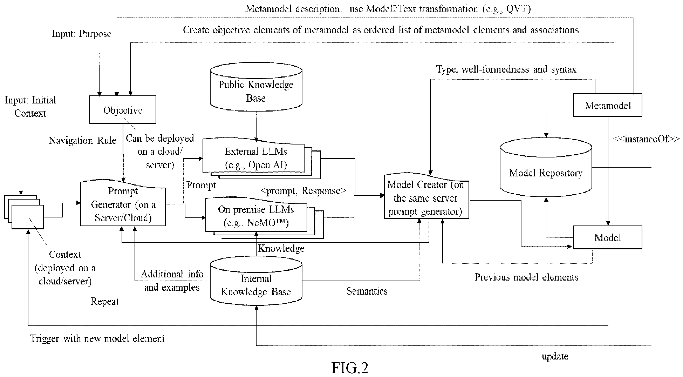

The memory 102 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. FIG.2 illustrates an input/output diagram of the system of FIG. 1, in accordance with some embodiments of the present disclosure. The memory 102 further comprises (or may further comprise) information pertaining to input(s)/output(s) of each step performed by the systems and methods of the present disclosure. In other words, input(s) fed at each step and output(s) generated at each step are comprised in the memory 102 and can be utilized in further processing and analysis, particularly functionalities represented by components/modules (described herein below) illustrated in FIG. 1 and FIG.2. The components are implemented as at least one of a logically self-contained part of a software program, a self-contained hardware component, and/or, a self-contained hardware component with a logically self-contained part of a software program embedded into each of the hardware component that when executed perform a method 400 described hereinafter. Accordingly, the components are invoked by the one or more hardware processors 104 to perform the method 400 of the present disclosure. In accordance with the present disclosure, the components that are comprised in the system 100 include:
- a prompt generator;
- a context component;
- an objective component;
- a model creator; and
- a model repository

Further components that support the system 100 include:
- an internal knowledge base;
- a public knowledge base;
- external LLM(s), for e.g., OpenAI;
- on premise LLM(s), for e.g., NeMO^{™}; and
- a metamodel.

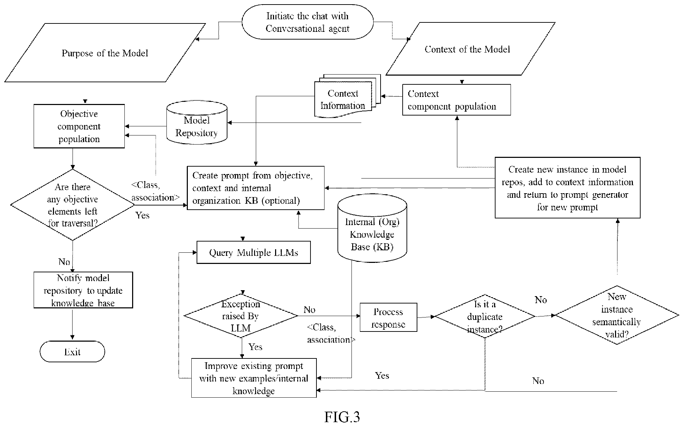

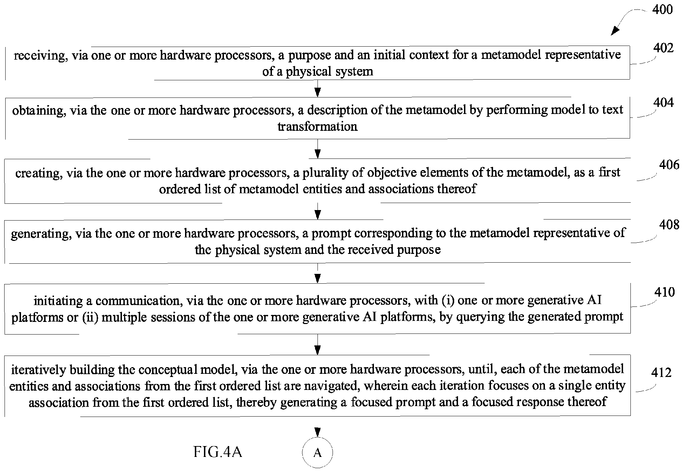

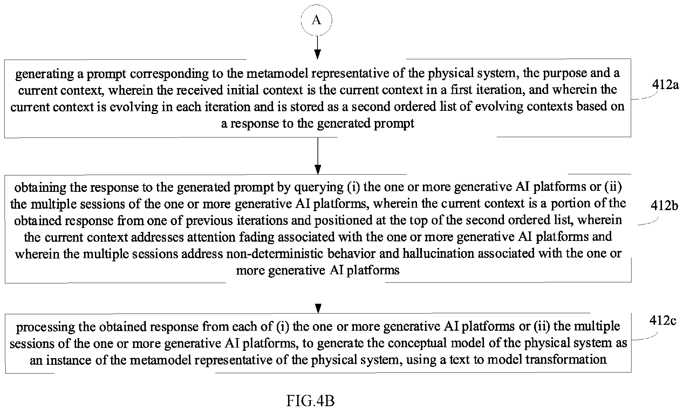

FIG.3 illustrates an exemplary flow diagram while FIG.4A through FIG.4B illustrate the computer implemented method respectively, for generating conceptual models of physical systems using symbiotic integration of generative AI and MDE, in accordance with some embodiments of the present disclosure. In an embodiment, the system 100 includes the memory 102 operatively coupled to the one or more hardware processors 104 and is configured to store instructions configured for execution of steps of the method 400 by the one or more hardware processors 104. The steps of the method 400 will now be explained in detail with reference to the components of the system 100 of FIG. 1 and the input/output diagram of the system as illustrated in FIG.2, in accordance with some embodiments of the present disclosure. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practical. Further, some steps may be performed simultaneously.

In accordance with the present disclosure, the one or more hardware processors 104, are configured to receive at step 402, a purpose and an initial context for a metamodel representative of a physical system. With reference to FIG.2 the objective component receives the purpose while context component receives the initial context. In an embodiment, the purpose and the initial context are provided by an SME.

In accordance with the present disclosure, the one or more hardware processors 104, are configured to obtain, at step 404, a description of the metamodel by performing model to text transformation. In an embodiment, the model to text transformation is performed using Query/View/Transformation (QVT) language. With reference to FIG.2 the objective component receives the description of the metamodel.

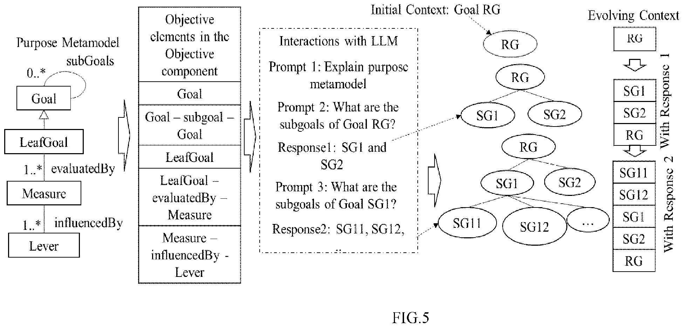

In accordance with the present disclosure, the one or more hardware processors 104, are configured to create, at step 406, a plurality of objective elements of the metamodel, as a first ordered list of metamodel entities and associations thereof. The objective elements are illustrated in FIG.5 that illustrates generative AI led knowledge exploration, in accordance with some embodiments of the present disclosure. The objective component navigates the metamodel entities and associations thereof in a predefined order of the first ordered list to enable prompt generation. For example, it starts from top level Goal and explores Goal-subgoal-Goal for identified goals, Goal-evaluatedBy-Measure for all leaf-level goals, and Measure-influencedBy-Lever associations as seen in FIG.5. The objective component ensures that all metamodel entities and associations are explored.

In accordance with the present disclosure, the one or more hardware processors 104, are configured to generate, at step 408, a prompt corresponding to the metamodel representative of the physical system and the received purpose. With reference to FIG.2, the prompt generator generates the prompt.

In accordance with the present disclosure, the one or more hardware processors 104, are configured to initiate a communication, at step 410, with (i) one or more generative AI platforms or (ii) multiple sessions of the one or more generative AI platforms, by querying the generated prompt. With reference to FIG.2 the one or more generative AI platforms are represented as external LLMs and on premise LLMs.

In accordance with the present disclosure, the one or more hardware processors 104, are configured to iteratively building the conceptual model, at step 412. The building of the conceptual model comprises generating a prompt corresponding to the metamodel representative of the physical system, the purpose, and a current context, at step 412a, by the prompt generator. In a first iteration, the received initial context is the current context. In accordance with the present disclosure, the current context is evolving in each iteration and is stored as a second ordered list of evolving contexts based on a response to the generated prompt. The second ordered list is typically a stack or queue of evolving contexts (in a breadth-first or depth-first manner) as shown in FIG.5 that sequentially supplies current context to the prompt generator.

In accordance with the present disclosure, the building of the conceptual model further comprises obtaining the response to the generated prompt, at step 412b, by querying (i) the one or more generative AI platforms or (ii) the multiple sessions of the one or more generative AI platforms. Referring to FIG.5, the current context is a portion of the obtained response from one of previous iterations and positioned at the top of the second ordered list. The attention fading limitation associated with the one or more generative AI platforms is addressed by the current context utilized in accordance with the present disclosure. Only necessary and sufficient local context based on model dependencies serve as current context to enable focused prompt generation for achieving a focused response.

Referring to FIG.5, root goal (RG) represents the initial context received by the context component. The prompt generator retrieves one model instance from the context component (i.e., to start with RG), extracts its type through the objective component (i.e., RG is a 'Goal') and asks prompts (questions) to explore associations, such as what are the subgoals (SGs) of goal RG? The zero-shot capability of LLM(s) is leveraged at this stage.

In accordance with the present disclosure, the building of the conceptual model finally comprises processing the obtained response from each of (i) the one or more generative AI platforms or (ii) the multiple sessions of the one or more generative AI platforms, at step 412c, to generate the conceptual model of the physical system as an instance of the metamodel representative of the physical system, using a text to model transformation. With reference to FIG.2, the model creator processes the obtained response to generate the conceptual model.

In accordance with the present disclosure, the iterative step 412 of building the conceptual model continues until each of the metamodel entities and associations from the first ordered list are navigated, wherein each iteration focuses on a single entity association from the first ordered list, thereby generating a focused prompt and a focused response thereof.

In accordance with the present disclosure, each generated prompt is associated with one objective element from the plurality of objective elements of the metamodel, where the objective element is associated with an entity or an association of an entity. The obtained response is linked with the generated prompt and the employed LLM. Essentially, the objective element and/or association along with current context is used for constructing the prompt. The one or more LLMs when queried by the prompt provides a response The tuple <Prompt, Response> leads to <new model elements> and a new entry in the context component. The tuple <Objective, Context> iteratively construct comprehensive <model elements> that represent a conceptual model of a physical system. The entire trace of this exploration is stored into the model repository, thereby enabling traceability of the generated conceptual models.

The process of generating the conceptual model of the physical system by processing the obtained response from each of (i) the one or more generative AI platforms or (ii) the multiple sessions of the one or more generative AI platforms is explained hereinafter. Firstly, the semantic validity of obtained response is assessed by querying an internal knowledge base. A model type is extracted from each response generated from (i) the one or more generative AI platforms or (ii) the multiple sessions of the one or more generative AI platforms. If the obtained response is semantically valid, the model creator creates an instance of the metamodel representative of the physical system based on the extracted model type, by parsing the obtained response. If the created instance of the metamodel is new and hence does not exist in the model repository, a model repository of generated conceptual models in each iteration is then updated with the created instance of the metamodel.

In accordance with the present disclosure, the created instance of the metamodel representative of the physical system is also added as the current context in the second ordered list of evolving contexts. The updated model repository is further added to the internal knowledge base for a next iteration associated with the purpose.

In accordance with the present disclosure, if the obtained response is not a semantically valid response, then (i) the one or more generative AI platforms or (ii) the multiple sessions of the one or more generative AI platforms are repeatedly queried with an updated prompt having additional information from the internal knowledge base. The additional information addresses hallucination associated with the LLMs. Further, if i) the one or more generative AI platforms or (ii) the multiple sessions of the one or more generative AI platforms return an error in the form of exceptions including network errors and Application Programming Interface (API) limit exceeded error, then the prompt is queried again.

### EXPERIMENTAL VALIDATION

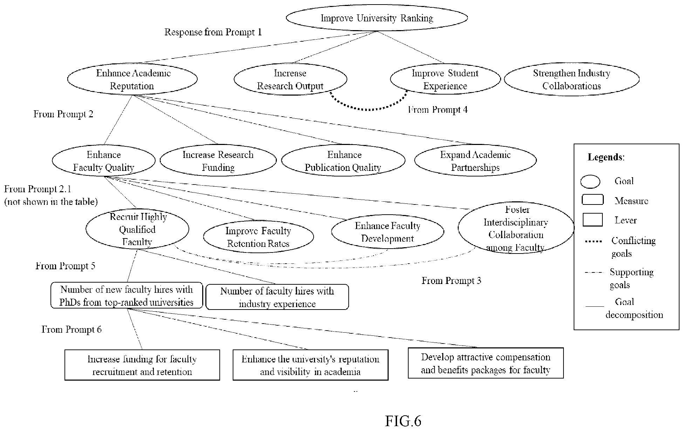

The method and system of the present disclosure were validated for development of digital twin based applications. ChatGPT^{™} was employed as an LLM for the validation. Table 1 herein below is referenced by FIG.6 that illustrates an extract of a use case of the computer implemented method of FIG.4A through FIG.4B, in accordance with some embodiments of the present disclosure. The use case pertains to a decision-making problem within the context of a hypothetical university. The university aims to enhance its ranking by identifying the most effective courses of action or levers. A scenario where the hypothetical University faces challenges in exploring potential levers within the real-world context has been explored. Therefore, a practical application of leveraging the power of digital twins to predict the consequences of these potential levers thus leading to informed decision making has been explored.

The method of the present disclosure draws on the general knowledge that ChatGPT^{™} has about universities in general. A prompt was generated considering the context, the response from ChatGPT^{™} was captured and a Goal-Measure-Lever (GML) meta model was instantiated, where a prompt is a textual description of a three-tuple of information: meta-model element and association to be explored next, the current model element, and previous context. A previous context was provided to overcome the fading context limitation of ChatGPT^{™}.

The interaction was initiated by providing "Improve university" as the top-level goal along with a textual description of the GML meta-model as shown in Prompt 1 of Table 1. The response from ChatGPT^{™} is captured as a model element which was then used to populate instance of GML meta-model. Further interaction was guided by navigating meta-model associations, instantiated model and previous context as shown in Table 1. For example, "Which subgoals support" is a textual representation of meta-model element *Goal* and related association *Goal.supports.Goal*, "subgoal 1.1.1" is the current model element to be considered, and "optional context..." is previous context in Prompt 3 of Table 1.

**Table 1:**

| **No.** | **Model element** | **An excerpt of prompts to the ChatGPT^{™}** |
|---|---|---|
| M1 | Goal | Prompt 1: I would like to create a model for a university that aims to improve its ranking. To capture domain information, I have a meta model, termed as Goal-Measure-Lever (GML) meta model, where we capture goal and objectives as "Goal", the KPIs that helps to understand the achievability of goals as "Measure" and potential actions/interventions as "Lever". Goal can be decomposed into one or more finer Goals (referred as subgoal). Goal can support each other or oppose. Leaf level goals in goal is associated to one or more "Measure" (KPI). We want to start with goal decomposition structure. What is the root goal and its immediate subgoals, i.e., one level goal decomposition structure - no more detailing please. |
| M2 | Goal-subgoal-Goal | Prompt 2: What are the subgoals of Sub-goal 1 - just one level decomposition structure please |
| M3 | Goal-supports-Goal | Prompt 3: Which subgoals support subgoal 1.1.1 + optional context [here are the subgoals of Sub-goal 1.1, which is to enhance faculty quality: |
| | | Subgoal 1.1.1: Recruit Highly Qualified Faculty |
| | | Subgoal 1.1.2: Improve Faculty Retention Rates |
| | | Subgoal 1.1.3: Enhance Faculty Development Programs |
| | | Subgoal 1.1.4: Foster Interdisciplinary Collaboration among Faculty. |
| M4 | Goal-opposes-Goal | Prompt 4: Which subgoal opposes subgoal 1.1.1 |
| M5 | Measure | Prompt 5: What are the measures for subgoal 1.1.1 |
| M6 | Lever | Prompt 6: Which levers influences the measure M1 "Number of new faculty hires with PhDs from top-ranked universities" of subgoal 1.1.1, less verbose |

**Table 1 (contd.):**

| **No.** | **An excerpt of responses from the ChatGPT^{™}** |
|---|---|
| M1 | Sure, here's a list of the root goal and its immediate subgoals for your university model: |
| | Goal: Improve University Ranking |
| | Subgoal 1: Enhance Academic Reputation |
| | Subgoal 2: Increase Research Output |
| | Subgoal 3: Improve Student Experience |
| | Subgoal 4: Strengthen Industry Collaborations |
| M2 | Certainly! Here are the subgoals of Sub-goal 1, which is to enhance academic reputation: |
| | Subgoal 1.1: Enhance Faculty Quality |
| | Subgoal 1.2: Increase Research Funding |
| | Subgoal 1.3: Enhance Publication Quality |
| | Subgoal 1.4: Expand Academic Partnerships |
| M3 | The following subgoals support Subgoal 1.1.1, which is to recruit highly qualified faculty: |
| | Subgoal 1.1.3: Enhance Faculty Development Programs: By enhancing the faculty development programs, the university can provide opportunities for professional growth and skill development for new faculty hires, which can make the university a more attractive workplace and contribute to the recruitment of highly qualified faculty. |
| | Subgoal 1.1.4: Foster Interdisciplinary Collaboration among Faculty...... |
| M4 | None of the subgoals under Sub-goal 1 appears to directly oppose Subgoal 1.3, which is to enhance publication quality......... |
| M5 | Subgoal 1.1.1 is to recruit highly qualified faculty. The measures associated with this subgoal will depend on the specific metrics that your university wants to focus on. Here are some potential measures that you could consider: |
| | Number of new faculty hires with PhDs from top-ranked universities |
| | Number of faculty hires with industry experience |
| | Number of faculty hires with research expertise in emerging fields |
| | Faculty retention rates |
| | Faculty diversity and inclusivity |
| | Faculty satisfaction surveys |
| M6 | To increase the measure "Number of new faculty hires with PhDs from top-ranked universities" of subgoal 1.1.1, the following levers could be considered: |
| | Lever 1: Increase funding for faculty recruitment and retention |
| | Lever 2: Enhance the university's reputation and visibility in academia |
| | Lever 3: Develop attractive compensation and benefits packages for faculty |
| | Lever 4: Offer professional development and mentoring opportunities to new faculty |
| | Lever 5: Establish partnerships with top-ranked universities to facilitate faculty recruitment |

The use case (illustrated representation of an instantiated GML model) as shown in FIG.6 was validated against traditional modeler-centric SME-aided approach. In the traditional approach, two faculties (SMEs) and a modeler spent 3 working days to construct the purpose model. In contrast, with the method and system of the present disclosure, a high level of similarity with the purpose model (~90%) using just one modeler and one SME (for validation) was achieved. The construction process took approximately 4 hours.

By leveraging the extensive general knowledge stored in LLMs, the method and system of the present disclosure reduces the cognitive burden on SMEs and expedites model construction process without compromising quality. The limitations of LLMs are addressed by combining MDE capabilities, providing a structured framework for generating prompts and navigating the conceptual model construction process iteratively. This symbiotic combination ensures that the outputs generated by LLMs are refined, leading to creation of more accurate and precise conceptual models.

The method and system of the present disclosure offers several advantages over the state of the art namely, faster model construction, reduced dependence on SMEs, and improved precision. In accordance with the present disclosure, obtaining responses from the multiple sessions of the one or more generative AI platforms help address non-deterministic behavior and hallucination associated with the one or more generative AI platforms. Few-shot capability of LLM(s) through the Internal knowledge base is leveraged, which enables the provision of purpose-specific internal information about the system to supplement the prompts with examples and/or additional details. The generation of focused prompts results in an optimized generation of number of prompts and addresses the limited context window size limitation of LLMs. The optimized generation of number of prompts further leads to efficient utilizing of computing power by the LLMs.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (400) comprising:
receiving, via one or more hardware processors, a purpose and an initial context for a metamodel representative of a physical system (402);
obtaining, via the one or more hardware processors, a description of the metamodel by performing model to text transformation (404);
creating, via the one or more hardware processors, a plurality of objective elements of the metamodel, as a first ordered list of metamodel entities and associations thereof (406);
generating, via the one or more hardware processors, a prompt corresponding to the metamodel representative of the physical system and the received purpose (408);
initiating a communication, via the one or more hardware processors, with (i) one or more generative Artificial Intelligence (AI) platforms or (ii) multiple sessions of the one or more generative AI platforms, by querying the generated prompt (410); and
iteratively building the conceptual model (412), via the one or more hardware processors, wherein the building of the conceptual model comprises:
generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt (412a);
obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms (412b); and
processing the obtained response from each of (i) the one or more generative AI platforms or (ii) the multiple sessions of the one or more generative AI platforms, to generate the conceptual model of the physical system as an instance of the metamodel representative of the physical system, using a text to model transformation (412c);
until, each of the metamodel entities and associations from the first ordered list are navigated, wherein each iteration focuses on a single entity association from the first ordered list, thereby generating a focused prompt and a focused response thereof.

2. The processor implemented method as claimed in claim 1, wherein the processing of the obtained response from each of (i) the one or more generative AI platforms or (ii) the multiple sessions of the one or more generative AI platforms, to generate the conceptual model of the physical system comprises:
assessing semantic validity of the obtained response from each of (i) the one or more generative AI platforms or (ii) the multiple sessions of the one or more generative AI platforms by querying an internal knowledge base;
extracting a model type from each response generated from (i) the one or more generative AI platforms or (ii) the multiple sessions of the one or more generative AI platforms;
creating an instance of the metamodel representative of the physical system based on the extracted model type by parsing the obtained response from each of (i) the one or more generative AI platforms or (ii) the multiple sessions of the one or more generative AI platforms, in the event that the obtained response is semantically valid; and
updating a model repository of generated conceptual models in each iteration with the created instance of the metamodel representative of the physical system if the created instance of the metamodel representative of the physical system does not exist in the model repository.

3. The processor implemented method as claimed in claim 2, wherein the step of assessing semantic validity of the obtained response from each of (i) the one or more generative AI platforms or (ii) the multiple sessions of the one or more generative AI platforms is repeated by querying (i) the one or more generative AI platforms or (ii) the multiple sessions of the one or more generative AI platforms, with an updated prompt having additional information from the internal knowledge base, if the obtained response is not a semantically valid response, and wherein the additional information addresses hallucination associated with the one more generative AI platforms.

4. The processor implemented method as claimed in claim 2, wherein the step of assessing semantic validity of the obtained response from each of (i) the one or more generative AI platforms or (ii) the multiple sessions of the one or more generative AI platforms is repeated by querying (i) the one or more generative AI platforms or (ii) the multiple sessions of the one or more generative AI platforms with a repeated prompt in the event that i) the one or more generative AI platforms or (ii) the multiple sessions of the one or more generative AI platforms return an error.

5. The processor implemented method as claimed in claim 2, wherein the step of updating a model repository of generated conceptual models in each iteration with the created instance of the metamodel representative of the physical system is followed by adding the created instance of the metamodel representative of the physical system as the current context in the second ordered list of evolving contexts.

6. The processor implemented method as claimed in claim 2, wherein the updated model repository is added to the internal knowledge base for a next iteration associated with the purpose.

7. A system (100) comprising:
a memory (102) storing instructions;
one or more communication interfaces (106); and
one or more hardware processors (104) coupled to the memory (102) via the one or more communication interfaces (106), wherein the one or more hardware processors (104) are configured by the instructions to:
receive a purpose and an initial context for a metamodel representative of a physical system;
obtain a description of the metamodel by performing model to text transformation;
create a plurality of objective elements of the metamodel, as a first ordered list of metamodel entities and associations thereof;
generate a prompt corresponding to the metamodel representative of the physical system and the received purpose;
initiate a communication, with (i) one or more generative Artificial Intelligence (AI) platforms or (ii) multiple sessions of the one or more generative AI platforms, by querying the generated prompt; and
iteratively build the conceptual model, wherein the building of the conceptual model comprises:
generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt;
obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms; and
processing the obtained response from each of (i) the one or more generative AI platforms or (ii) the multiple sessions of the one or more generative AI platforms, to generate the conceptual model of the physical system as an instance of the metamodel representative of the physical system, using a text to model transformation;
until, each of the metamodel entities and associations from the first ordered list are navigated, wherein each iteration focuses on a single entity association from the first ordered list, thereby generating a focused prompt and a focused response thereof.

8. The system as claimed in claim 7, wherein the one or more processors are configured to process the obtained response from each of (i) the one or more generative AI platforms or (ii) the multiple sessions of the one or more generative AI platforms, to generate the conceptual model of the physical system by:
assessing semantic validity of the obtained response from each of (i) the one or more generative AI platforms or (ii) the multiple sessions of the one or more generative AI platforms by querying an internal knowledge base;
extracting a model type from each response generated from (i) the one or more generative AI platforms or (ii) the multiple sessions of the one or more generative AI platforms;
creating an instance of the metamodel representative of the physical system based on the extracted model type by parsing the obtained response from each of (i) the one or more generative AI platforms or (ii) the multiple sessions of the one or more generative AI platforms, in the event that the obtained response is semantically valid; and
updating a model repository of generated conceptual models in each iteration with the created instance of the metamodel representative of the physical system if the created instance of the metamodel representative of the physical system does not exist in the model repository.

9. The system as claimed in claim 7, wherein the one or more processors are configured to assess semantic validity of the obtained response from each of (i) the one or more generative AI platforms or (ii) the multiple sessions of the one or more generative AI platforms by repeatedly querying (i) the one or more generative AI platforms or (ii) the multiple sessions of the one or more generative AI platforms, with an updated prompt having additional information from the internal knowledge base, if the obtained response is not a semantically valid response, and wherein the additional information addresses hallucination associated with the one more generative AI platforms.

10. The system as claimed in claim 7, wherein the one or more processors are configured to assess semantic validity of the obtained response from each of (i) the one or more generative AI platforms or (ii) the multiple sessions of the one or more generative AI platforms by repeatedly querying (i) the one or more generative AI platforms or (ii) the multiple sessions of the one or more generative AI platforms with the generated prompt in the event that i) the one or more generative AI platforms or (ii) the multiple sessions of the one or more generative AI platforms return an error.

11. The system as claimed in claim 7, wherein the one or more processors are further configured by the instructions to add the created instance of the metamodel representative of the physical system as the current context in the second ordered list of evolving contexts.

12. The system as claimed in claim 7, wherein the one or more processors are further configured by the instructions to add the updated model repository to the internal knowledge base for a next iteration associated with the purpose.

13. One or more non-transitory machine-readable information storage mediums comprising one or more instructions which when executed by one or more hardware processors cause:
receiving, a purpose and an initial context for a metamodel representative of a physical system;
obtaining a description of the metamodel by performing model to text transformation;
creating, a plurality of objective elements of the metamodel, as a first ordered list of metamodel entities and associations thereof;
generating a prompt corresponding to the metamodel representative of the physical system and the received purpose;
initiating a communication with (i) one or more generative Artificial Intelligence (AI) platforms or (ii) multiple sessions of the one or more generative AI platforms, by querying the generated prompt; and
iteratively building the conceptual model, wherein the building of the conceptual model comprises:
generating a prompt corresponding to the metamodel representative of the physical system, the purpose and a current context, wherein the received initial context is the current context in a first iteration, and wherein the current context is evolving in each iteration and is stored as a second ordered list of evolving contexts based on a response to the generated prompt;
obtaining the response to the generated prompt by querying (i) the one or more generative AI platforms or (ii) the multiple sessions of the one or more generative AI platforms, wherein the current context is a portion of the obtained response from one of previous iterations and positioned at the top of the second ordered list, wherein the current context addresses attention fading associated with the one or more generative AI platforms and wherein the multiple sessions address non-deterministic behavior and hallucination associated with the one or more generative AI platforms; and
processing the obtained response from each of (i) the one or more generative AI platforms or (ii) the multiple sessions of the one or more generative AI platforms, to generate the conceptual model of the physical system as an instance of the metamodel representative of the physical system, using a text to model transformation;
until, each of the metamodel entities and associations from the first ordered list are navigated, wherein each iteration focuses on a single entity association from the first ordered list, thereby generating a focused prompt and a focused response thereof.

14. The one or more non-transitory machine-readable information storage mediums as claimed in claim 13, wherein the one or more instructions which when executed by the one or more hardware processors further cause processing of the obtained response from each of (i) the one or more generative AI platforms or (ii) the multiple sessions of the one or more generative AI platforms, to generate the conceptual model of the physical system by:
assessing semantic validity of the obtained response from each of (i) the one or more generative AI platforms or (ii) the multiple sessions of the one or more generative AI platforms by querying an internal knowledge base;
extracting a model type from each response generated from (i) the one or more generative AI platforms or (ii) the multiple sessions of the one or more generative AI platforms;
creating an instance of the metamodel representative of the physical system based on the extracted model type by parsing the obtained response from each of (i) the one or more generative AI platforms or (ii) the multiple sessions of the one or more generative AI platforms, in the event that the obtained response is semantically valid;
updating a model repository of generated conceptual models in each iteration with the created instance of the metamodel representative of the physical system if the created instance of the metamodel representative of the physical system does not exist in the model repository;
adding the created instance of the metamodel representative of the physical system as the current context in the second ordered list of evolving contexts; and
adding the updated model repository to the internal knowledge base for a next iteration associated with the purpose.

15. The one or more non-transitory machine-readable information storage mediums as claimed in claim 13, wherein the one or more instructions which when executed by the one or more hardware processors further cause assessing semantic validity of the obtained response from each of (i) the one or more generative AI platforms or (ii) the multiple sessions of the one or more generative AI platforms repeatedly by querying (i) the one or more generative AI platforms or (ii) the multiple sessions of the one or more generative AI platforms, with (a) an updated prompt having additional information from the internal knowledge base, if the obtained response is not a semantically valid response, and wherein the additional information addresses hallucination associated with the one more generative AI platforms; or (b) a repeated prompt in the event that i) the one or more generative AI platforms or (ii) the multiple sessions of the one or more generative AI platforms return an error.
